# EUROPÄISCHE PATENTSCHRIFT

(11) **EP 1 717 871 B1**
(45) Veröffentlichungstag und Bekanntmachung des Hinweises auf die Patenterteilung: **02.05.2018**
(21) Anmeldenummer: 06004660.4
(22) Anmeldetag: 07.03.2006
(51) Int. Cl.: H01L 33/48, H01L 33/62, H01L 31/0203, H05K 3/34

(54) **Oberflächenmontierbares optoelektronisches Bauelement**
Optoelectronic surface-mountable component
Composant optoélectronique montable en surface

(30) Priorität: 15.04.2005 DE 102005017527
(43) Veröffentlichungstag der Anmeldung: 02.11.2006
(73) Patentinhaber: OSRAM Opto Semiconductors GmbH, 93055 Regensburg (DE)
(72) Erfinder: Ferstl, Christian, 93073 Neutraubling (DE)
(74) Vertreter: Epping - Hermann - Fischer

(56) Entgegenhaltungen:
- WO-A-2004/077558
- JP-A- 5 218 509
- JP-A- 6 037 359
- JP-A- 8 264 842
- JP-A- 2001 326 387
- JP-A- 2003 060 240
- US-A1- 2005 009 242
- US-A1- 2005 045 903
- US-B1- 6 344 689

## Beschreibung

Die Erfindung betrifft ein oberflächenmontierbares optoelektronisches Bauelement gemäß dem Oberbegriff des Patentanspruchs 1.

Oberflächenmontierbare optoelektronische Bauelemente werden in der Regel mittels Lötverbindungen auf einer Leiterplatte, insbesondere einer gedruckten Leiterplatte (PCB, Printed Circuit Board) befestigt.

Ein oberflächenmontierbares Halbleiterbauelement, das mittels einer Lötverbindung auf einem PCB befestigt ist, ist beispielsweise aus der DE 697 09 172 T2 bekannt. Insbesondere ist in der Figur 4 dieser Druckschrift ein oberflächenmontierbares Bauelement (SMD, Surface Mounted Device) dargestellt, das mittels einer Lötstelle im Bereich der Seitenfläche des Gehäuses auf einem PCB befestigt ist. Das Lot bildet dabei eine äußere Lotkehle zwischen dem PCB und der Gehäuseseitenfläche und eine innere Lotkehle zwischen dem PCB und der Gehäusebodenfläche aus. Da das Lot beim Aufschmelzen unter der Gehäusebodenfläche teilweise von der Gewichtskraft des Gehäuses verdrängt wird, andererseits an der Seitenfläche des Gehäuses aber nicht verdrängt wird, sind die äußere Lotkehle und die innere Lotkehle asymmetrisch ausgebildet.

Durch die Lotkehlen wird aufgrund der Oberflächenspannung des Lots jeweils eine Kraft auf das Gehäuse des Bauelements ausgeübt, wobei die Kräfte jeweils eine zur Lotkehle hin gerichtete tangentiale, also parallel zur Oberfläche des Gehäusebodens bzw. des Trägersubstrats wirkende Komponente aufweisen. Aufgrund der nicht zueinander symmetrischen Form der äußeren und der inneren Lotkehle kompensieren sich die tangential wirkenden Kräfte in der Regel nicht. Insbesondere ist die von der äußeren Lotkehle auf das Gehäuse ausgeübte tangentiale Kraft in der Regel größer als die entgegengesetzt wirkende tangentiale Kraft der inneren Lotkehle.

Die resultierende auf das Gehäuse einwirkende Tangentialkraft kann zu einer Rissbildung in der Lotstelle führen. Weiterhin besteht die Gefahr, dass die tangential wirkende Kraft ein Drehmoment auf den Gehäusekörper ausübt, das insbesondere beim Lötvorgang, wenn das Lot noch aufgeschmolzen ist, zu einer Verkippung des Gehäuses gegenüber der Trägeroberfläche führen kann. Dieser sogenannte Tombstoning-Effekt kann insbesondere bei optoelektronischen Bauelementen, die ein vergleichsweise leichtes Kunststoffgehäuse ohne Leiterrahmen aufweisen, auftreten. Der prinzipielle Aufbau eines derartigen Bauelements ohne Leiterrahmen ist zum Beispiel aus der WO 2004/077558 bekannt. JP 05-218509 offenbart ein oberflächenmontierbares optoelektronisches Bauelement, das einen Gehäusekörper aufweist, der eine Gehäusegrundfläche und mindestens eine erste Gehäuseseitenfläche und eine zweite Gehäuseseitenfläche aufweist, wobei die erste Gehäuseseitenfläche und die zweite Gehäuseseitenfläche einander gegenüberliegen und sich die Gehäusegrundfläche von der von der ersten Gehäuseseitenfläche in Richtung zur zweiten Gehäuseseitenfläche hin erstreckt, mit einer ersten Anschlussstelle, die an der Gehäusegrundfläche angeordnet ist und der ersten Gehäuseseitenfläche benachbart ist, und einer zweiten Anschlussstelle, die an der Gehäusegrundfläche angeordnet ist und der zweiten Gehäuseseitenfläche benachbart ist, wobei das Bauelement an den Anschlussstellen mit einem Trägerkörper mittels eines Lots verbunden ist, wobei der Gehäusekörper eine an die erste und zweite Anschlussstelle angrenzende Ausnehmung aufweist, die sich von der Gehäusegrundfläche in den Gehäusekörper hinein erstreckt, wobei jeweils eine äussere Lotkehle an den Gehäuseseitenflächen und eine innere Lotkehle an die an die Anschlussstellen angrenzenden Seitenflächen der Ausnehmung durch das Lot ausgebildet sind, und die innere Lotkehle und die äussere Lotkehle zueinander symmetrisch sind.

Der Erfindung liegt die Aufgabe zu Grunde, ein verbessertes oberflächenmontierbares optoelektronisches Bauelement anzugeben, das zur Lötmontage auf einen Trägerkörper vorgesehen ist, bei dem insbesondere ein durch die Lotkehlen auf den Gehäusekörper ausgeübtes resultierende Drehmoment vermindert ist.

Diese Aufgabe wird durch ein oberflächenmontierbares optoelektronisches Bauelement gemäß Patentanspruch 1 gelöst. Vorteilhafte Ausgestaltungen und Weiterbildungen der Erfindung sind Gegenstand der abhängigen Ansprüche.

Ein oberflächenmontierbares optoelektronisches Bauelement gemäß der Erfindung weist einen Gehäusekörper auf, der eine Gehäusegrundfläche und mindestens eine erste Gehäuseseitenfläche und eine zweite Gehäuseseitenfläche aufweist, wobei die erste Gehäuseseitenfläche und die zweite Gehäuseseitenfläche einander gegenüberliegen und sich die Gehäusegrundfläche von der von der ersten Gehäuseseitenfläche in Richtung zur zweiten Gehäuseseitenfläche hin erstreckt. Weiterhin ist eine Anschlussstelle an der Gehäusegrundfläche angeordnet und der ersten Gehäuseseitenfläche benachbart, wobei die Anschlussstelle zur Verbindung des Bauelements mit einem Trägerkörper mittels eines Lots vorgesehen ist. Der Gehäusekörper weist eine an die Anschlussstelle angrenzende Ausnehmung auf, die sich von der Gehäusegrundfläche in den Gehäusekörper hinein erstreckt, wobei die Ausbildung einer äußeren Lotkehle an der ersten Gehäuseseitenfläche und einer inneren Lotkehle an einer an die Anschlussstelle angrenzenden Seitenfläche der Ausnehmung durch das Lot vorgesehen ist.

In einen Teilbereich der an die an die Anschlussstelle angrenzende Ausnehmung kann das Lot beim Aufschmelzen während des Lötvorgangs vorteilhaft eindringen, um an einer der Anschlussstelle zugewandten Seitenfläche der Ausnehmung eine innere Lotkehle auszubilden, die im Vergleich zu einer inneren Lotkehle, die sich bei einem herkömmlichen Gehäuse unterhalb der Gehäusegrundfläche ausbilden würde, vergleichsweise groß ist. Vorteilhaft weisen die innere und die äußere Lotkehle eine im wesentlichen gleiche Höhe gegenüber der Trägeroberfläche und/oder eine im wesentlichen gleiche Krümmung auf. Die innere und die äußere Lotkehle sind zueinander symmetrisch.

Auf diese Weise wird vorteilhaft ein Drehmoment, das durch die äußere Lotkehle auf den Gehäusekörper ausgeübt wird, durch ein durch die innere Lotkehle auf den Gehäusekörper ausgeübtes entgegengesetztes Drehmoment vermindert oder sogar kompensiert. Vorzugsweise ist das Drehmoment zumindest derart vermindert, dass der Gehäusekörper durch ein auf ihn wirkendes Drehmoment beim Lötvorgang, wenn das Lot noch aufgeschmolzen ist, nicht verkippt wird. Weiterhin wird auf diese Weise auch einer Rissbildung in der Lotstelle vorgebeugt.

Bei einer vorteilhaften Ausgestaltung der Erfindung verjüngt sich ein Querschnitt der Ausnehmung ausgehend von der Gehäusegrundfläche zum Inneren des Gehäusekörpers hin. Bevorzugt weist die Ausnehmung einen V-förmigen oder trapezförmigen Querschnitt auf. Die Ausnehmung weist eine an die Anschlussstelle angrenzende metallisierte Seitenfläche und eine nicht metallisierte Seitenfläche auf. Auf diese Weise wird vorteilhaft erreicht, dass sich die innere Lotkehle an der metallisierten Seitenfläche der Ausnehmung und insbesondere nicht an der nicht metallisierten Seitenfläche der Ausnehmung ausbildet.

Das optoelektronische Bauelement basiert vorzugsweise auf der Molded Interconnected Device (MID)-Technologie. Der Gehäusekörper enthält vorteilhaft mindestens zwei verschiedene Kunststoffe, wobei einer der Kunststoffe nicht metallisierbar ist und einer der Kunststoffe metallisierbar ist, wobei der Gehäusekörper an der Oberfläche des metallisierbaren Kunststoffs eine Metallisierung aufweist.

Der Gehäusekörper kann insbesondere durch ein Zweikomponenten-Spritzgussverfahren hergestellt sein, wobei die Zweikomponenten durch einen metallisierbaren und einen nicht metallisierbaren Kunststoff gebildet sind.

Die Metallisierung ist bevorzugt durch einen Isoliersteg, der aus dem nicht metallisierbaren Kunststoff gebildet ist, in mindestens zwei elektrisch voneinander getrennte Metallisierungsbereiche aufgeteilt.

Die Ausnehmung ist vorteilhaft derart an einer Grenzfläche zwischen einem metallisierten Bereich des metallisierbaren Kunststoffs und einem Bereich des nicht metallisierbaren Kunststoffs ausgebildet, dass sie eine der angrenzenden Anschlussstelle zugewandte metallisierte Seitenfläche und eine gegenüberliegende nicht metallisierte Seitenfläche aufweist.

Besonders vorteilhaft ist die Erfindung für Gehäusekörper, die im Gegensatz zu herkömmlichen Gehäuseformen, bei denen in der Regel ein metallischer Leiterrahmen von einem Kunststoff umspritzt ist, keinen Leiterrahmen aufweisen. Da ein derartiges Gehäuse, das keinen Leiterrahmen umfasst, ein vergleichsweise geringes Gewicht aufweist, ist bei einem derartigen Gehäuse die Gefahr des Verkippen des Gehäusekörpers bei der Lötmontage durch ein auf den Gehäusekörper einwirkendes Drehmoment vergleichsweise groß.

Das optoelektronische Bauelement umfasst bei einer bevorzugten Ausführungsform mindestens einen strahlungsempfangenden oder strahlungsemittierenden Halbleiterchip, beispielsweise einen Lumineszenzdiodenchip oder einen Laserdiodenchip.

Der Halbleiterchip ist vorzugsweise in einer weiteren Ausnehmung des Gehäusekörpers angeordnet, die nicht an der Gehäusegrundfläche ausgebildet ist. Die weitere Ausnehmung ist vorteilhaft mit einer Metallisierung versehen, die als Reflektor für die von dem strahlungsemittierenden Halbleiterchip emittierte Strahlung dient.

Die weitere Ausnehmung, in welcher der Halbleiterchip angeordnet ist, kann z.B. an einer der Gehäusegrundfläche gegenüberliegenden Fläche des Gehäusekörpers ausgebildet sein.

Alternativ kann die weitere Ausnehmung, in der der Halbleiterchip angeordnet ist, auch an einer vertikal zur Gehäusegrundfläche angeordneten Fläche des Gehäusekörpers ausgebildet sein. Insbesondere kann das optoelektronische Bauelement einen Lumineszenzdiodenchip oder Laserdiodenchip enthalten, der eine Hauptstrahlungsrichtung parallel zur Gehäusegrundfläche aufweist. Gemäß der Erfindung ist eine zweite Anschlussstelle an der Gehäusegrundfläche angeordnet und der zweiten Gehäuseseitenfläche benachbart, wobei die zweite Anschlussstelle zur Verbindung des Bauelements mit einem Trägerkörper mittels eines Lots vorgesehen ist und der Gehäusekörper eine an die zweite Anschlussstelle angrenzende zweite Ausnehmung aufweist, die sich von der Gehäusegrundfläche in den Gehäusekörper hinein erstreckt, wobei die Ausbildung einer äußeren Lotkehle an der zweiten Gehäuseseitenfläche und einer inneren Lotkehle an einer an die zweite Anschlussstelle angrenzenden Seitenfläche der zweiten Ausnehmung durch das Lot vorgesehen ist. Für die zweite Ausnehmung an der Gehäusegrundfläche gelten die zuvor beschrieben Vorteile und bevorzugten Ausgestaltungen der ersten Ausnehmung in entsprechender Weise.

Bei dieser Ausführungsform ist ein strahlungsemittierender und/oder strahlungsempfangender Halbleiterchip vorzugsweise mit einem ersten elektrischen Kontakt mit der ersten Anschlussstelle und mit einem zweiten elektrischen Kontakt mit der zweiten Anschlussstelle elektrisch leitend verbunden. Die elektrisch leitende Verbindung zwischen dem Halbleiterchip und der ersten Anschlussstelle und der zweiten Anschlussstelle erfolgt vorzugsweise jeweils mittels der zuvor beschriebenen elektrisch voneinander isolierten Metallisierungsbereiche, wobei ein erster Metallisierungsbereich die erste Anschlussstelle und ein zweiter Metallisierungsbereich die zweite Anschlussstelle umfasst. Beispielsweise ist ein erster elektrischer Kontakt des Halbleiterchips mit einem ersten Metallisierungsbereich elektrisch leitend verbunden und ein zweiter elektrischen Kontakt des Halbleiterchips mit dem zweiten Metallisierungsbereich elektrisch leitend verbunden. Auf diese Weise ist der Halbleiterchip über den ersten Metallisierungsbereich mit der ersten Anschlussstelle und über den zweiten Metallisierungsbereich mit der zweiten Anschlussstelle elektrisch leitend verbunden.

Weiterhin kann zumindest einer der Metallisierungsbereiche vorteilhaft gleichzeitig eine optische Funktion aufweisen, insbesondere kann ein metallisierter Bereich des Gehäusekörpers als Reflektor für elektromagnetische Strahlung, die von einem an den Gehäusekörper angeordneten strahlungsemittierenden Halbleiterchip emittiert wird, dienen.

Die Erfindung wird im Folgenden anhand eines Ausführungsbeispiels im Zusammenhang mit der Figur näher erläutert.

Die Figur zeigt eine schematische Darstellung eines Querschnitts durch ein oberflächenmontierbares optoelektronisches Bauelement mit einem Trägerkörper gemäß einem Ausführungsbeispiel der Erfindung.

Das in der Figur dargestellte oberflächenmontierbare optoelektronische Bauelement gemäß einem Ausführungsbeispiel der Erfindung umfasst einen Gehäusekörper 1, der an einer einem Träger 2 zugewandten Gehäusegrundfläche 9 eine erste Anschlussstelle 7 und eine zweite Anschlussstelle 8 aufweist. An der ersten Anschlussstelle 7 und der zweiten Anschlussstelle 8 ist der Gehäusekörper 1 jeweils mit einem Lot 10 mit einem Trägerkörper 2 verbunden. Der Trägerkörper 2 ist beispielsweise eine Leiterplatte, insbesondere ein Printed Circuit Board (PCB). Insbesondere kann der Trägerkörper 2 mit Leiterbahnen 3, 4 versehen sein, mit denen das optoelektronische Bauelement an den Anschlussstellen 7, 8 mittels dem Lot 10 elektrisch leitend verbunden ist.

An der Gehäusegrundfläche 9 sind in dem Gehäusekörper 1 zwei Ausnehmungen 11, 12 ausgebildet. Die erste Ausnehmung 11 grenzt an die erste Anschlussstelle 7 und die zweite Ausnehmung 12 an die zweite Anschlussstelle 8 an. Die erste Anschlussstelle 7 grenzt an einer von der ersten Ausnehmung 11 abgewandten Seite an eine erste Gehäuseseitenfläche 15 des Gehäusekörpers 1 an, und die zweite Anschlussstelle 8 grenzt an einer von der zweiten Ausnehmung 12 abgewandten Seite an eine zweite Gehäuseseitenfläche 16 des Gehäusekörpers 1 an.

Das Lot 10 bildet an den Anschlussstellen 7, 8 jeweils eine äußere Lotkehle 17, die von dem Trägerkörper 2 zu der an die Anschlussstelle 7, 8 angrenzende Gehäuseseitenfläche 15, 16 verläuft, und eine innere Lotkehle 18, die jeweils von dem Trägerkörper 2 zu einer an die der Anschlussstelle 7, 8 angrenzende Seitenfläche 13, 14 der Ausnehmung 11, 12 verläuft, aus.

Die äußeren Lotkehlen 17 üben jeweils ein Drehmoment M₁ auf den Gehäusekörper 1 aus. Die inneren Lotkehlen 18 üben jeweils ein Drehmoment M₂, das dem Drehmoment M₁ entgegengerichtet ist, auf den Gehäusekörper 1 aus. Das von den äußeren Lotkehlen 18 ausgeübte Drehmoment M₁ wird auf diese Weise durch das entgegengerichtete Drehmoment M₂ vorteilhaft vermindert oder besonders bevorzugt sogar kompensiert. Somit ist die Gefahr, dass der Gehäusekörper 1 durch ein durch die äußere Lotkehle 17 ausgeübtes Drehmoment M₁ beim Lötvorgang, wenn das Lot 10 noch nicht erstarrt ist, derart verkippt wird, dass beispielsweise die Gehäusegrundfläche 9 nicht parallel zur Oberfläche des Trägerkörpers 2 verläuft. Weiterhin wird durch die Verminderung des resultierenden Drehmoments einer Rissbildung in dem Lot 10 vorgebeugt.

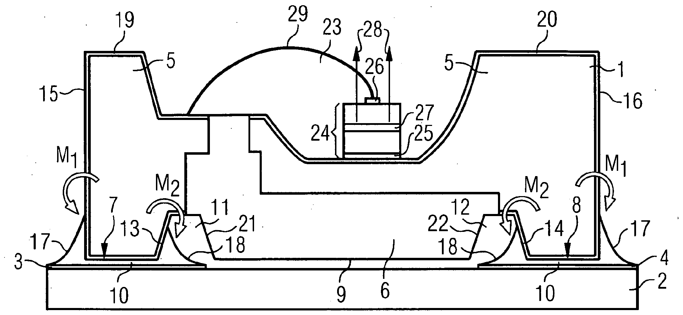

Bevorzugt verjüngt sich ein Querschnitt der Ausnehmungen 11, 12 ausgehend von einer Ebene, die von der Gehäusegrundfläche 9 gebildet wird, zum Inneren des Gehäusekörpers 1 hin. Beispielsweise können die Ausnehmungen 11, 12, wie in Figur 1 dargestellt, einen trapezförmigen Querschnitt aufweisen. Alternativ können die Ausnehmungen auch eine andere Querschnittsfläche, beispielsweise einen V-förmigen oder halbkreisförmiger Querschnitt aufweisen.

Der Gehäusekörper 1 enthält vorteilhaft mindestens zwei miteinander verbundenen Gehäuseteile 5, 6. Insbesondere kann der Gehäusekörper 1 ein erstes Gehäuseteil 5, das aus einem metallisierbaren Kunststoff gebildet ist, und ein zweites Gehäuseteil 6, das aus einem nicht metallisierbaren Kunststoff gebildet ist, enthalten. Ein derartiger Gehäusekörper 1 wird z.B. in einem Zweikomponenten-Spritzgussverfahren hergestellt, wobei der metallisierbare Kunststoff des ersten Gehäuseteils 5 die erste Komponente und der nicht metallisierbare Kunststoff des zweiten Gehäuseteils 6 die zweite Komponente ist.

Zumindest ein Teil der Oberfläche des Gehäuseteils 5, das aus dem metallisierbaren Kunststoff besteht, ist mit einer Metallisierung 19, 20 versehen. Das Gehäuseteil 6 aus dem nicht metallisierbaren Kunststoff ist dagegen an seiner Oberfläche nicht metallisiert und stellt vorteilhaft einen Isoliersteg dar, der die auf das Gehäuseteil 5 aufgebrachte Metallisierung 19, 20 in zwei elektrisch voneinander isolierte Bereiche unterteilt, wobei ein erster Metallisierungsbereich 19 die erste Anschlussstelle 7 umfasst und ein zweiter Metallisierungsbereich 20 die zweite Anschlussstelle 8 umfasst.

Die Ausnehmungen 11, 12 sind vorzugsweise jeweils derart an einer Grenzfläche zwischen dem Gehäuseteil 5 aus dem metallisierbaren Kunststoff und dem Gehäuseteil 6 aus dem nicht metallisierbaren Kunststoff angeordnet, dass sie jeweils eine der angrenzenden Anschlussstelle 7, 8 zugewandte Seitenfläche 13, 14, die von einer Oberfläche des metallisierbaren Kunststoffteils 5 gebildet wird, und eine gegenüberliegende Seitenfläche 21, 22, die von einer Oberfläche des nicht metallisierten Kunststoffteils 6 gebildet wird, aufweisen. Die Seitenflächen 13, 14 der Ausnehmung, die an die Anschlussstellen 7, 8 angrenzen, sind vorzugsweise jeweils ein Teilbereich der Metallisierungsbereiche 19, 20 versehen. Dies hat den Vorteil, dass sich die inneren Lotkehlen 18 jeweils an den metallisierten Seitenflächen 13, 14 und nicht an den gegenüberliegenden Seitenflächen 21, 22 der Ausnehmungen ausbilden.

Das optoelektronische Bauelement umfasst vorzugsweise mindestens einen strahlungsemittierenden und/oder strahlungsempfangenden Halbleiterchip, der z.B. in einer der Gehäusegrundfläche 9 gegenüberliegenden Ausnehmung 23 des Gehäusekörpers 1 angeordnet ist. Beispielsweise ist der Halbleiterchip ein strahlungsemittierender Halbleiterchip 24, der eine aktive Zone 27 umfasst, aus der elektromagnetische Strahlung 28, beispielsweise ultraviolettes, sichtbares oder infrarotes Licht, emittiert wird.

Der Halbleiterchip 24 enthält vorzugsweise ein III-V-Verbindungshalbleitermaterial, insbesondere InₓAl_{y}Ga_{1-x-y}N, InₓAl_{y}Ga_{1-x-y}P oder InₓAl_{y}Ga_{1-x-y}As, jeweils mit 0≤x≤1, 0≤y≤1 und x+y≤1. Dabei muss das III-V-Verbindungshalbleitermaterial nicht zwingend eine mathematisch exakte Zusammensetzung nach einer der obigen Formeln aufweisen. Vielmehr kann es einen oder mehrere Dotierstoffe sowie zusätzliche Bestandteile aufweisen, die die physikalischen Eigenschaften des Materials im Wesentlichen nicht ändern. Der Einfachheit halber beinhalten obige Formeln jedoch nur die wesentlichen Bestandteile des Kristallgitters, auch wenn diese teilweise durch geringe Mengen weiterer Stoffe ersetzt sein können.

Der strahlungsemittierende Halbleiterchip 24 weist vorteilhaft einen ersten Kontakt, beispielsweise ein Bondpad 26, auf, über die der Halbleiterchip 24 beispielsweise mit einem Bonddraht 29 mit dem ersten Metallisierungsbereich 19 elektrisch leitend verbunden ist. Weiterhin weist der strahlungsemittierende Halbleiterchip 24 eine zweiten Kontakt, beispielsweise eine Kontaktmetallisierung 25 auf, mit welcher der Halbleiterchip 24 mit dem zweiten Metallisierungsbereich 20 elektrisch leitend verbunden ist. Auf diese Weise ist der erste Kontakt 26 des Halbleiterchips über den Bonddraht 29 und den ersten Metallisierungsbereich 19 mit der ersten Anschlussstelle 7 elektrisch leitend verbunden und der zweite Kontakt 25 über den zweiten Metallisierungsbereich 20 mit der zweiten Anschlussstelle 8 elektrisch leitend verbunden. Die elektrische Kontaktierung des Halbleiterchips erfolgt vorteilhaft also im Gegensatz zu optoelektronische Bauelementen, die einen der Leiterrahmen aufweisen, über metallisierte Bereich der Oberfläche des Gehäusekörpers 1.

Die der Ausnehmung 23 zugewandten Oberflächen der Metallisierungsbereiche 19, 20 stellen vorteilhaft eine reflektionserhöhende Schicht für die von dem strahlungsemittierenden Halbleiterchip 24 emittierte Strahlung 28 dar. Die Metallisierungsbereiche 19, 20 haben also vorteilhaft einerseits die elektrische Funktion, den Halbleiterchip 24 mit den Anschlussstellen 7, 8 elektrisch leitend zu verbinden und andererseits die optische Funktion, in Richtung des Gehäusekörpers 1 emittierte Strahlung zu reflektieren, um insbesondere die Strahlungsintensität einer Hauptstrahlungsrichtung zu erhöhen oder die Gehäuseteile 5, 6 aus Kunststoff vor UV-Strahlung zu schützen.

## Patentansprüche

1. Oberflächenmontierbares optoelektronisches Bauelement mit einem Trägerkörper (2), das einen Gehäusekörper (1) aufweist, der eine Gehäusegrundfläche (9) und mindestens eine erste Gehäuseseitenfläche (15) und eine zweite Gehäuseseitenfläche (16) aufweist, wobei die erste Gehäuseseitenfläche (15) und die zweite Gehäuseseitenfläche (16) einander gegenüberliegen und sich die Gehäusegrundfläche (9) von der ersten Gehäuseseitenfläche (15) in Richtung zur zweiten Gehäuseseitenfläche (16) hin erstreckt, mit einer ersten Anschlussstelle (7), die an der Gehäusegrundfläche (9) angeordnet ist und der ersten Gehäuseseitenfläche (15) benachbart ist, und einer zweiten Anschlussstelle (8), die an der Gehäusegrundfläche (9) angeordnet ist und der zweiten Gehäuseseitenfläche (16) benachbart ist, wobei das Bauelement an den Anschlussstellen (7, 8) mit dem Trägerkörper (2) mittels eines Lots (10) verbunden ist,
wobei der Gehäusekörper (1) eine an die erste Anschlussstelle (7) angrenzende erste Ausnehmung (11) und eine an die zweite Anschlussstelle (8) angrenzende zweite Ausnehmung (12) aufweist, die sich von der Gehäusegrundfläche (9) in den Gehäusekörper (1) hinein erstrecken, wobei jeweils eine äußere Lotkehle (17) an den Gehäuseseitenflächen (15, 16) und eine innere Lotkehle (18) an den an die Anschlussstellen (7, 8) angrenzenden Seitenflächen (13, 14) der Ausnehmungen (11, 12) durch das Lot (10) ausgebildet sind, und die innere Lotkehle (17) und die äußere Lotkehle (18) zueinander symmetrisch sind,
wobei die Ausnehmungen (11, 12) jeweils eine an die Anschlussstelle (7, 8) angrenzende metallisierte Seitenfläche (13, 14) und eine nicht metallisierte Seitenfläche (21, 22) aufweisen, und wobei die inneren Lotkehlen (18) an der metallisierten Seitenfläche (13, 14) ausgebildet sind.

2. Oberflächenmontierbares optoelektronisches Bauelement nach Anspruch 1,
wobei ein Drehmoment (M₁), das durch die äußeren Lotkehlen (17) auf den Gehäusekörper (1) ausgeübt wird, durch ein durch die inneren Lotkehlen (18) auf den Gehäusekörper (1) ausgeübtes entgegengesetztes Drehmoment (M₂) vermindert ist.

3. Oberflächenmontierbares optoelektronisches Bauelement nach Anspruch 1 oder 2,
wobei sich ein Querschnitt der Ausnehmungen (11, 12) ausgehend von der Gehäusegrundfläche (9) zum Inneren des Gehäusekörpers (1) hin verjüngt.

4. Oberflächenmontierbares optoelektronisches Bauelement nach einem der vorhergehenden Ansprüche,
wobei die Ausnehmungen (11, 12) einen V-förmigen oder trapezförmigen Querschnitt aufweisen.

5. Oberflächenmontierbares optoelektronisches Bauelement nach einem der vorhergehenden Ansprüche,
wobei der Gehäusekörper (1) mindestens zwei verschiedene Kunststoffe enthält (5, 6), wobei einer der Kunststoffe (6) nicht metallisierbar ist und einer der Kunststoffe (5) metallisierbar ist, und der Gehäusekörper (1) an der Oberfläche des metallisierbaren Kunststoffs (5) eine Metallisierung (19, 20) aufweist.

6. Oberflächenmontierbares optoelektronisches Bauelement nach Anspruch 5,
wobei die Metallisierung (19, 20) durch einen Isoliersteg, der aus dem nichtmetallisierbaren Kunststoff (6) gebildet ist, in mindestens zwei elektrisch voneinander getrennte Metallisierungsbereiche (19, 20) aufgeteilt ist.

7. Oberflächenmontierbares optoelektronisches Bauelement nach Anspruch 6,
wobei einer der Metallisierungsbereiche (19) die metallisierten Seitenflächen (13, 14) der Ausnehmungen (11, 12) enthält, und die nicht metallisierten Seitenflächen (21, 22) der Ausnehmungen (11, 12) ein Teil der Oberfläche des nicht metallisierbaren Kunststoffs (6) ist.

8. Oberflächenmontierbares optoelektronisches Bauelement nach einem der vorhergehenden Ansprüche,
wobei das Bauelement keinen Leiterrahmen aufweist.

9. Oberflächenmontierbares optoelektronisches Bauelement nach einem der vorhergehenden Ansprüche,
wobei es mindestens einen strahlungsemittierenden oder strahlungsempfangenden Halbleiterchip (24) umfasst.

10. Oberflächenmontierbares optoelektronisches Bauelement nach Anspruch 9,
wobei der Halbleiterchip (24) in einer weiteren Ausnehmung (23) des Gehäusekörpers (1) angeordnet ist, die nicht an der Gehäusegrundfläche (9) ausgebildet ist.

11. Oberflächenmontierbares optoelektronisches Bauelement nach Anspruch 10,
wobei die weitere Ausnehmung (23) an einer der Gehäusegrundfläche (1) gegenüberliegenden Fläche des Gehäusekörpers (1) ausgebildet ist.

12. Oberflächenmontierbares optoelektronisches Bauelement nach Anspruch 10,
wobei die weitere Ausnehmung an einer vertikal zur Gehäusegrundfläche angeordneten Oberfläche des Gehäusekörpers ausgebildet ist.

## Claims

1. Surface-mountable optoelectronic component having a carrier body (2) which has a housing body (1), which has a housing base area (9) and at least a first housing side area (15) and a second housing side area (16), the first housing side area (15) and the second housing side area (16) lying opposite one another and the housing base area (9) extending from the first housing side area (15) in the direction toward the second housing side area (16), comprising a first connection location (7), which is arranged at the housing base area (9) and is adjacent to the first housing side area (15), and a second connection location (8), which is arranged at the housing base area (9) and is adjacent to the second housing side area (16), the component on the connection locations (7, 8) being connected to the carrier body (2) by means of a solder (10),
wherein
the housing body (1) has a first cutout (11) adjoining the first connection location (7) and a second cutout (12) adjoining the second connection location (8), which extend from the housing base area (9) into the housing body (1), in each case an outer solder fillet (17) being formed at the housing side areas (15, 16) and an inner solder fillet (18) being formed at the side areas (13, 14) of the cutouts (11, 12) that adjoin the connection locations (7, 8) by the solder (10), and the inner solder fillet (17) and the outer solder fillet (18) being symmetrical to one another, the cutouts (11, 12) in each case having a metalized side area (13, 14) adjoining the connection location (7, 8) and a nonmetalized side area (21, 22), and the inner solder fillets (18) being formed at the metalized side area (13, 14).

2. Surface-mountable optoelectronic component according to Claim 1,
wherein
a torque (M₁) exerted on the housing body (1) by the outer solder fillets (17) is reduced by an opposite torque (M₂) exerted on the housing body (1) by the inner solder fillets (18).

3. Surface-mountable optoelectronic component according to Claim 1 or 2,
wherein
a cross section of the cutouts (11, 12) tapers proceeding from the housing base area (9) toward the interior of the housing body (1).

4. Surface-mountable optoelectronic component according to one of the preceding claims,
wherein
the cutouts (11, 12) have a V-shaped or trapezoidal cross section.

5. Surface-mountable optoelectronic component according to one of the preceding claims,
wherein
the housing body (1) contains at least two different plastics (5, 6), one of the plastics (6) not being metalizable and one of the plastics (5) being metalizable, and the housing body (1) has a metalization (19, 20) at the surface of the metalizable plastic (5).

6. Surface-mountable optoelectronic component according to Claim 5,
wherein
the metalization (19, 20) is divided into at least two metalization regions (19, 20), which are electrically isolated from one another, by an insulating web formed from the nonmetalizable plastic (6).

7. Surface-mountable optoelectronic component according to Claim 6,
wherein
one of the metalization regions (19) contains the metalized side areas (13, 14) of the cutouts (11, 12), and the nonmetalized side areas (21, 22) of the cutouts (11, 12) are a part of the surface of the nonmetalizable plastic (6).

8. Surface-mountable optoelectronic component according to one of the preceding claims,
wherein
the component has no leadframe.

9. Surface-mountable optoelectronic component according to one of the preceding claims,
wherein
it comprises at least one radiation-emitting or radiation-receiving semiconductor chip (24).

10. Surface-mountable optoelectronic component according to Claim 9,
wherein
the semiconductor chip (24) is arranged in a further cutout (23) of the housing body (1), which further cutout is not formed at the housing base area (9).

11. Surface-mountable optoelectronic component according to Claim 10,
wherein
the further cutout (23) is formed at an area of the housing body (1) that lies opposite to the housing base area (1).

12. Surface-mountable optoelectronic component according to Claim 10,
wherein
the further cutout is formed at a surface of the housing body that is arranged vertically with respect to the housing base area.

## Revendications

1. Composant optoélectronique pouvant être monté en surface, comprenant un corps porteur (2) qui possède un corps de boîtier (1), lequel possède une surface de base de boîtier (9) et au moins une première surface latérale de boîtier (15) et une deuxième surface latérale de boîtier (16), la première surface latérale de boîtier (15) et la deuxième surface latérale de boîtier (16) se trouvant l'une en face de l'autre et la surface de base de boîtier (9) s'étendant depuis la première surface latérale de boîtier (15) en direction de la deuxième surface latérale de boîtier (16), comprenant un premier point de raccordement (7) qui est disposé sur la surface de base de boîtier (9) et qui est voisin de la première surface latérale de boîtier (15), et un deuxième point de raccordement (8) qui est disposé sur la surface de base de boîtier (9) et qui est voisin de la deuxième surface latérale de boîtier (16), le composant étant relié au niveau des points de raccordement (7, 8) au corps porteur (2) au moyen d'un brasage (10),
le corps de boîtier (1) possédant une première cavité (11) adjacente du premier point de raccordement (7) et une deuxième cavité (12) adjacente du deuxième point de raccordement (8), lesquelles s'étendent depuis la surface de base de boîtier (9) vers l'intérieur du corps de boîtier (1), une gorge de brasure externe (17) sur les surfaces latérales de boîtier (15, 16) et une gorge de brasure interne (18) sur les surfaces latérales (13, 14) des cavités (11, 12), surfaces latérales qui sont adjacentes des points de raccordement (7, 8), étant respectivement formées par le brasage (10), et la gorge de brasure interne (17) et la gorge de brasure externe (18) étant symétrique l'une par rapport à l'autre,
les cavités (11, 12) possédant respectivement une surface latérale métallisée (13, 14) adjacente du point de raccordement (7, 8) et une surface latérale non métallisée (21, 22), et les gorges de brasure internes (18) étant formées sur la surface latérale métallisée (13, 14).

2. Composant optoélectronique pouvant être monté en surface selon la revendication 1, un couple (M₁) qui est exercé par les gorges de brasure externes (17) sur le corps de boîtier (1) étant réduit par un couple (M₂) opposé exercé par les gorges de brasure internes (18) sur le corps de boîtier (1).

3. Composant optoélectronique pouvant être monté en surface selon la revendication 1 ou 2, une section transversale des cavités (11, 12) diminuant à partir de la surface de base de boîtier (9) en direction de l'intérieur du corps de boîtier (1).

4. Composant optoélectronique pouvant être monté en surface selon l'une des revendications précédentes, les cavités (11, 12) possédant une section transversale en forme de V ou de forme trapézoïdale.

5. Composant optoélectronique pouvant être monté en surface selon l'une des revendications précédentes, le corps de boîtier (1) contenant au moins deux matières plastiques (5, 6) différentes, l'une des matières plastiques (6) n'étant pas métallisable et l'une des matières plastiques (5) étant métallisable, et le corps de boîtier (1) possédant une métallisation (19, 20) sur la surface de la matière plastique métallisable (5).

6. Composant optoélectronique pouvant être monté en surface selon la revendication 5, la métallisation (19, 20) étant formée par une moulure isolante qui est constituée de la matière plastique non métallisable (6), dans laquelle sont réparties au moins deux zones de métallisation (19, 20) séparées électriquement l'une de l'autre.

7. Composant optoélectronique pouvant être monté en surface selon la revendication 6, l'une des zones de métallisation (19) contenant les surfaces latérales métallisées (13, 14) des cavités (11, 12), et les surfaces latérales non métallisées (21, 22) des cavités (11, 12) étant une partie de la surface de la matière plastique non métallisable (6).

8. Composant optoélectronique pouvant être monté en surface selon l'une des revendications précédentes, le composant ne possédant pas de grille de connexion.

9. Composant optoélectronique pouvant être monté en surface selon l'une des revendications précédentes, celui-ci comprenant au moins une puce en semiconducteur (24) émettrice de rayonnement ou réceptrice de rayonnement.

10. Composant optoélectronique pouvant être monté en surface selon la revendication 9, la puce en semiconducteur (24) étant disposée dans une cavité supplémentaire (23) du corps de boîtier (1), qui n'est pas formée sur la surface de base de boîtier (9).

11. Composant optoélectronique pouvant être monté en surface selon la revendication 10, la cavité supplémentaire (23) étant formée sur une surface du corps de boîtier (1) à l'opposé de la surface de base de boîtier (1).

12. Composant optoélectronique pouvant être monté en surface selon la revendication 10, la cavité supplémentaire étant formée sur une surface du corps de boîtier disposée verticalement par rapport à la surface de base de boîtier.
